# EUROPÄISCHE PATENTSCHRIFT

(11) **EP 0 628 209 B1**
(45) Veröffentlichungstag und Bekanntmachung des Hinweises auf die Patenterteilung: **12.06.1996**
(21) Anmeldenummer: 93903815.4
(22) Anmeldetag: 18.02.1993
(51) Int. Cl.: H01H 1/00, G01L 9/00

(54) **VERFAHREN ZUM HERSTELLEN EINES DRUCKDIFFERENZ-SENSORS**
PROCESS FOR MAKING A SENSOR FOR DIFFERENTIAL PRESSURE
PROCEDE DE FABRICATION D'UN DETECTEUR SENSIBLE A UNE DIFFERENCE DE PRESSION

(30) Priorität: 28.02.1992 DE 4206677
(43) Veröffentlichungstag der Anmeldung: 14.12.1994
(73) Patentinhaber: SIEMENS AKTIENGESELLSCHAFT, D-80333 München (DE)
(72) Erfinder: SCHLAAK, Helmut, D-1000 Berlin 33 (DE); ARNDT, Frank, D-1000 Berlin 12 (DE)
(86) Internationale Anmeldenummer: DE9300152
(87) Internationale Veröffentlichungsnummer: WO9317440

(56) Entgegenhaltungen:
- EP-A- 0 007 596
- EP-A- 0 394 664
- DE-U- 9 105 851
- US-A- 4 592 238
- US-A- 4 766 666

## Beschreibung

Die Erfindung bezieht sich auf ein Verfahren zum Herstellen eines Druckdifferenz-Sensors mit einer Silizium Meßmembran, die zwischen zwei scheibenförmigen Tragteilen aus Glas unter Bildung jeweils einer Innenkammer eingespannt ist, wobei die eine Innenkammer über eine Durchgangsöffnung in dem einen Tragteil mit einem Druck und die andere Innenkammer mit einem weiteren Druck der zu messenden Druckdifferenz beaufschlagbar ist.

Ein derartiges Verfahren ist der EP-A-0 007 596 entnehmbar. Bei diesem bekannten Verfahren wird die aus Silizium bestehende Meßmembran in der Weise hergestellt, daß eine Silizium-Scheibe auf ihren beiden Seiten zunächst mit Bor dotiert und außen befindliche Oxidschichten durch Photo-Ätzen unter Bildung einer Maske teilweise entfernt werden. Anschließend werden von der Silizium-Scheibe beidseitig durch beispielsweise Säure-Ätzen die dotierten Bereiche abgetragen und anschließend auch die Maske entfernt. Danach wird die fertige Meßmembran an ihrem Rande durch Bonden mit jeweils einer Glasscheibe als Tragteil verbunden; jede Glasscheibe trägt auf ihrer Innenseite als Elektrode eine aufgedampfte Metallschicht.

Der Erfindung liegt die Aufgabe zugrunde, das bekannte Verfahren so weiter zu entwickeln, daß mit ihm allein durch eine entsprechende Tragteilausgestaltung ein überlastsicherer Druckdifferenz-Sensor herstellbar ist.

Zur Lösung dieser Aufgabe wird bei einem Verfahren der eingangs angegebenen Art erfindungsgemäß zumindest das die andere Innenkammer begrenzende weitere Tragteil vor dem Einspannen der Silizium-Meßmembran mit einer Ausnehmung mit schrägen Flanken mit einer sehr geringen Steigung versehen, indem auf Oberflächenbereiche des scheibenförmigen Tragteils entsprechend den herzustellenden schrägen Flanken eine durch eine isotrop wirkende Ätzflüssigkeit abtragbare, dünne Schicht aufgetragen wird, anschließend die dünne Schicht mit einer für die isotrop wirkende Ätzflüssigkeit unangreifbaren Ätzmaske abgedeckt und danach das isotrope Ätzen vorgenommen wird.

Es ist zwar unter anderem aus der DE-A-32 15 411 ein Verfahren zum Herstellen einer Ausnehmung mit schrägen Flanken in einem Substrat bekannt, bei dem auf Oberflächenbereiche des Substrats entsprechend der herzustellenden Ausnehmung eine durch eine isotrop wirkende Ätzflüssigkeit abtragbare Schicht aufgetragen wird, die abtragbare Schicht mit einer für eine isotrop wirkende Ätzflüssigkeit unangreifbaren Ätzmaske abgedeckt wird und anschließend ein isotropes Ätzes vorgenommen wird, jedoch wird dieses Verfahren angewendet, um an Öffnungskanten einen sehr scharfen, rechtwinkligen Verlauf zu vermeiden. Über scharfe öffnungskanten geführte Metallkontaktierungsbahnen können nämlich aufreißen.

Ferner ist der EP-A-0 394 664 ein Verfahren zum Herstellen einer Silizium-Meßmembran für einen Druck-Sensor entnehmbar, bei dem in ein Substrat aus Silizium durch anisotropes Ätzen zunächst eine Ausnehmung mit einer schrägen Flanke in Trapezform eingeätzt wird. Um der insoweit hergestellten Silizium-Meßmembran eine von der Druckbelastungsrichtung unabhängige, große Bruchfestigkeit zu verleihen, wird im Anschluß an das anisotrope Ätzen ein isotropes Ätzen vorgenommen. Dies erfolgt mit einer isotrop wirkenden Ätzflüssigkeit, nachdem Oberflächenbereiche der Scheibe aus Silizium entsprechend der herzustellenden Ausnehmung mit einer für die isotrop wirkende Ätzflüssigkeit unangreifbaren Ätzmaske, beispielsweise aus Siliziumnitrid, abgedeckt worden sind. Durch das isotrope Ätzen wird die Ausnehmung allseitig unter Verrundung der Ecken etwas vergrößert mit dem Vorteil, daß die Druckbelastbarkeit der Membran von beiden Seiten etwa gleich groß ist.

Der erfindungsgemäße Druckdifferenz-Sensor hat den großen Vorteil, daß er infolge der Ausbildung der Ausnehmung in seinem weiteren Tragteil ohne zusätzliche Maßnahmen überlastsicher ist, weil sich die Halbleiter-Meßmembran in die Ausnehmung bei Überlast ohne Bruchgefährdung einschmiegen kann. Bei dem Druckdifferenz-Sensor kann es sich um einen solchen handeln, mit dem eine Druckdifferenz im herkömmlichen Sinne erfaßbar ist. In diesem Falle ist auch das eine Tragteil mit einer Ausnehmung gemäß der Erfindung versehen. Der Druckdifferenz-Sensor kann aber selbstverständlich auch als Druckmeßgerät verwendet werden, indem beispielsweise in dem weiteren Tragteil eine Durchgangsöffnung nicht vorgesehen ist und die mit diesem weiteren Tragteil und der Halbleiter-Meßmembran gebildete Innenkammer evakuiert ist oder Atmosphärendruck aufweist.

Bei einer bevorzugten Anwendung des erfindungsgemäßen Verfahrens wird die dünne Schicht aus Titan in einer Stärke von etwa 50 nm hergestellt und die Ätzmaske aus Gold gebildet. Dabei ergibt sich eine Steigung von etwa 2 - 3° der schrägen Flanke in einem Substrat aus Glas bei Verwendung von gepufferter Flußsäure. Bei Silizium als Substrat kann die Ätzflüssigkeit z.B. Flußsäure mit einem Zusatz eines Oxidationsmittels (z.B. HNO₃) sein.

Zum Herstellen von Ausnehmungen mit schrägen Flanken unterschiedlicher Steigung wird vorteilhafterweise die Dicke der Schicht und deren Werkstoff entsprechend der geforderten Steigung der schrägen Flanke ausgeführt. Je flacher die Steigung der schrägen Flanke sein soll, umso größer muß das Verhältnis der Ätzgeschwindigkeit der durch die isotrop wirkende Ätzflüssigkeit abtragbaren Schicht zur Ätzgeschwindigkeit im Substrat sein. Die Dicke der Schicht hat insofern für die Steigung der schrägen Flanke Bedeutung, als die Abtragsgeschwindigkeit wesentlich von dem Austausch der isotrop wirkenden Ätzflüssigkeit an der Angriffsfläche der Schicht abhängig ist. Ist der Austausch an isotrop wirkender Ätzflüssigkeit an bestimmten Oberflächenbereichen des Substrats behindert, dann ergibt sich eine relativ geringe Abtragsgeschwindigkeit. Dies wird im Rahmen der Erfindung bewußt ausgenutzt, weil sich unter der von der isotrop wirkenden Ätzflüssigkeit nicht angegriffenen Ätzmaske gewissermaßen eine ringförmige Tasche zunehmender Tiefe bildet, in der die isotrop wirkende Ätzflüssigkeit relativ schlecht ausgetauscht wird. Insofern ergibt sich im Querschnitt betrachtet unterhalb der Ätzmaske eine schräge Flanke mit relativ geringer Steigung, wobei es im Hinblick auf die vorangestellten Ausführungen verständlich sein dürfte, daß die Steigung der schrägen Flanke umso geringer ist, je dünner die Schicht unterhalb der Ätzmaske ausgeführt ist. Durch die Dicke dieser Schicht ist also die Steigung der schrägen Flanke auch beeinflußbar.

Zur Erläuterung der Erfindung ist in
- Figur 1: in mehreren Darstellungen das bekannte Herstellen einer Ausnehmung in einer Scheibe aus Siliziummaterial, in
- Figur 2: ein Querschnitt durch einen nach dem erfindungsgemäßen Verfahren hergestellten Druckdifferenz-Sensor mit in Tragteilen hergestellten Ausnehmungen und in
- Figur 3: ein vergrößerter Ausschnitt aus der Figur 2 wiedergegeben.

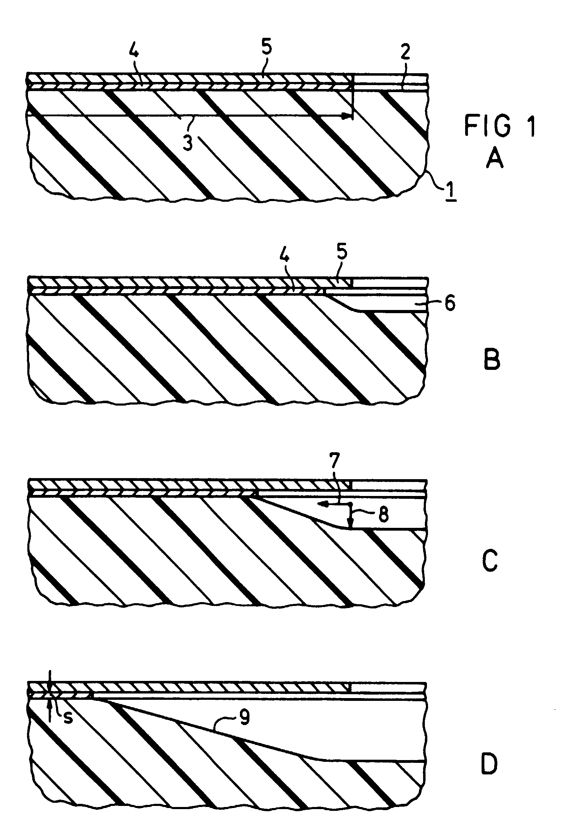

Die Darstellung A der Figur 1 zeigt einen Ausschnitt aus einer Glasscheibe 1 als Substrat, die an ihrer Seite 2 mit einer Ausnehmung versehen werden soll. Zu diesem Zweck ist auf einen Oberflächenbereich 3 der Glasscheibe 1 eine Schicht 4 aus einem Material (beispielsweise Titan) aufgebracht, das von einem isotrop wirkenden Ätzmittel abtragbar ist; bei diesem Ätzmittel kann es sich z.B. um Flußsäure handeln. Auf die Schicht 4 ist eine Ätzmaske 5 aufgebracht, die von einem gegenüber dem isotrop wirkenden Ätzmittel resistenten Material (z.B. Gold) gebildet ist.

Wird die gemäß Darstellung A in der geschilderten Weise vorbereitete Glasscheibe 1 dem isotrop wirkenden Ätzmittel ausgesetzt, dann erfolgt mit fortdauerndem Angriff des isotrop wirkenden Ätzmittels die Bildung einer zunehmend größer werdenden Ausnehmung 6, wie den Darstellungen B bis D der Figur 1 zu entnehmen ist. Dabei ist der Abtrag in Richtung des Pfeiles 7 größer als in Richtung des Pfeiles 8, weil die Ätzgeschwindigkeit in der Schicht 4 größer als in der Glasscheibe 1 ist. Die Steigung der schrägen Flanke 9 der Ausnehmung 6 ist auch von der Dicke s der Schicht 4 abhängig. Je dünner die Schicht 4 ist, umso stärker ist der Austausch des isotropen Ätzmittels im Bereich zwischen der Schicht 5 und der sich darunter ausbildenden Ausnehmung 6 behindert. Demzufolge ist dann der Abtrag in Richtung des Pfeiles 7 vermindert, so daß die Steigung der schrägen Flanke 9 größer wird. Durch die Dicke s der Schicht 4 und ihren Werkstoff läßt sich also die gewünschte Steigung der schrägen Flanke einstellen.

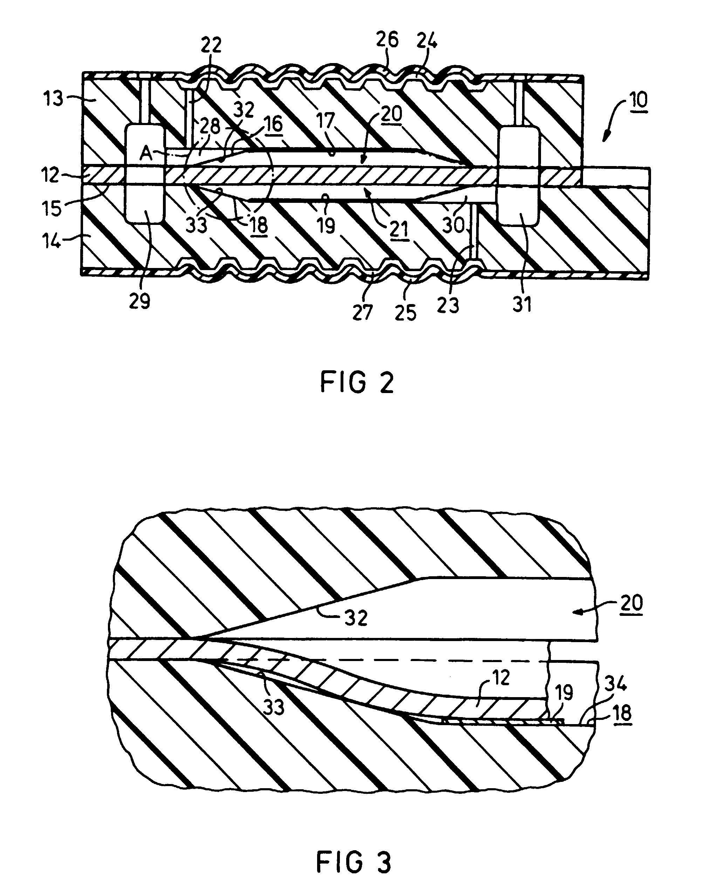

Der in Figur 2 gezeigte Druckdifferenz-Sensor 10 weist eine Silizium-Meßmembran 12 auf. Die Silizium-Meßmembran 12 ist zwischen einem in der Figur 2 oberen Tragteil 13 und einem weiteren - in der Figur 2 unteren -Tragteil 14 eingespannt. Sowohl das eine Tragteil 13 als auch das weitere Tragteil 14 bestehen aus Glas. Die Silizium-Meßmembran 12 ist mit den beiden Tragteilen 13 und 14 in ihrem Bereich 15 durch Bonden fest eingespannt. Das eine Tragteil 13 ist - wie in Figur 1 dargestelltisotrop so geätzt, daß eine Ausnehmung 16 mit dem dargestellten Querschnitt entsteht, die in ihrem Grunde eine flächenhafte Elektrode 17 trägt. In entsprechender Weise ist das weitere Tragteil 14 durch Ätzen mit einer Ausnehmung 18 versehen, die eine weitere flächenhafte Elektrode 19 aufweist. Die Ausnehmungen 16 bzw. 18 bilden zusammen mit der Silizium-Meßmembran 12 jeweils eine Innenkammer 20 und 21, die über jeweils eine Bohrung 22 bzw. 23 in den Tragteilen 13 bzw. 14 mit jeweils einer Vorkammer 24 bzw. 25 unter Trennmembranen 26 und 27 verbunden sind. Darüber hinaus ist die eine Innenkammer 20 über einen seitlichen Kanal 28 mit einer Ausgleichskammer 29 verbunden. Entsprechend ist die weitere Innenkammer 21 über einen weiteren seitlichen Kanal 30 mit einer weiteren Ausgleichskammer 31 verbunden.

Sowohl die Ausnehmung 16 als auch die Ausnehmung 18 weisen jeweils eine schräge Flanke 32 bzw. 33 auf, die durch ein Ausätzen der Ausnehmungen 16 und 18 in der oben geschilderten Weise gewonnen sind.

In Figur 3 ist der in Figur 2 strichpunktiert gekennzeichnete Ausschnitt A vergrößert dargestellt. Es ist hier ferner der Fall veranschaulicht, daß die Silizium-Meßmembran 12 infolge einer Überlastung durch einen Überdruck in der Innenkammer 20 soweit ausgelenkt ist, daß sie sich gegen die Elektrode 19 auf dem Grund 34 der Ausnehmung 18 legt. Durch die schräge Flanke 33 mit relativ geringer Steigung ist dafür gesorgt, daß sich die Silizium-Meßmembran 12 in ihrem ausgelenkten Bereich nicht so stark verbiegt, daß sie bricht; außerdem ist dafür gesorgt, daß sie sich auch im Bereich der schrägen Flanke 33 gegen diese anlegt. Dadurch ist ein Brechen der Silizium- Meßmembran 12 bei Überlast verhindert und somit ein Druckdifferenz-Sensor geschaffen, der ohne weitere Maßnahmen überlastsicher ist.

## Patentansprüche

1. Verfahren zum Herstellen eines Druckdifferenz-Sensors mit einer Silizium-Meßmembran (12), die zwischen zwei scheibenförmigen Tragteilen aus Glas (13, 14) unter Bildung jeweils einer Innenkammer (20, 21) eingespannt ist, wobei die eine Innenkammer über eine Durchgangsöffnung in dem einen Tragteil mit einem Druck und die andere Innenkammer mit einem weiteren Druck der zu messenden Druckdifferenz beaufschlagbar ist,
**dadurch gekennzeichnet**, daß
- zumindest das die andere Innenkammer (21) begrenzende weitere Tragteil (14) vor dem Einspannen der Silizium-Meßmembran (12) mit einer Ausnehmung (18) mit schrägen Flanken (33) mit einer sehr geringen Steigung versehen wird, indem
- auf Oberflächenbereiche des scheibenförmigen Tragteils (14) entsprechend den herzustellenden schrägen Flanken (33) eine durch eine isotrop wirkende Ätzflüssigkeit abtragbare, dünne Schicht (4) aufgetragen wird,
- anschließend die dünne Schicht mit einer für die isotrop wirkende Ätzflüssigkeit unangreifbaren Ätzmaske (5) abgedeckt wird und
- danach das isotrope Ätzen vorgenommen wird.

2. Verfahren nach Anspruch 1,
**dadurch gekennzeichnet** , daß
- die dünne Schicht aus Titan in einer Stärke von etwa 50 nm hergestellt wird und
- die Ätzmaske aus Gold gebildet wird.

3. Verfahren nach Anspruch 1 oder 2,
**dadurch gekennzeichnet**, daß
- die Dicke der dünnen Schicht (4) und deren Werkstoff entsprechend der geforderten Steigung der schrägen Flanke (9) ausgeführt wird.

## Claims

1. Process for manufacturing a pressure-difference sensor having a silicon measuring diaphragm (12) that is clamped between two discoid support elements made of glass (13, 14), each forming an inner chamber (20, 21), the one inner chamber being able to be pressurised by one pressure via a through-hole in the one support element, and the other inner chamber being able to be pressurised by another pressure of the pressure-difference to be measured,
**characterised in that**
- prior to the clamping of the silicon measuring diaphragm (12), at least the additional support element (14) delimiting the other inner chamber (21) is provided with a recess (18) with inclined sides (33) having a very slight gradient,
- by depositing a thin layer (4) on the surface regions of the discoid support element (14) in accordance with the inclined sides (33) to be produced, said thin layer (4) being removable by an isotropic etchant,
- the thin layer is then covered by an etching mask (5) which cannot be attacked by the isotropic etchant, and
- after which the isotropic etching is carried out.

2. Process according to Claim 1,
characterised in that
- the thin layer is made from titanium having a thickness of approximately 50 nm and
- the etching mask is formed from gold.

3. Process according to Claim 1 or 2,
characterised in that
- the thickness of the thin layer (4) and its material is selected according to the required gradient of the inclined side (9).

## Revendications

1. Procédé de fabrication d'un capteur de différence de pression comportant une membrane (12) de mesure en silicium, qui est bloquée entre deux pièces de support en verre (13, 14) et en forme de disque tout en formant chacune une chambre intérieure (20, 21), l'une des chambres intérieures pouvant être soumise par l'intermédiaire d'une ouverture de passage dans l'une des pièces de support à une pression et l'autre chambre intérieure pouvant être soumise à une autre pression de la différence de pression à mesurer,
caractérisé en ce que
- on ménage au moins dans l'autre pièce (14) de support délimitant l'autre chambre (21) intérieure, avant le blocage de la membrane (12) de mesure en silicium un évidement (18) à flancs (33) obliques de très petite pente, par le fait que
- on dépose sur des zones de la surface de la pièce (14) de support en forme de disque, en fonction des flancs (33) obliques à fabriquer une couche (4) mince pouvant être enlevée par un fluide d'attaque chimique agissant de manière isotrope,
- on recouvre ensuite la couche mince d'un masque (5) d'attaque chimique ne pouvant pas être attaquée par le fluide d'attaque chimique agissant de manière isotrope puis
- on procède à l'attaque chimique isotrope.

2. Procédé suivant la revendication 1,
caractérisé en ce que
- on fabrique la couche mince en titane d'une épaisseur d'environ 50 nm et
- on forme le masque d'attaque chimique en or.

3. Procédé suivant la revendication 1 ou 2,
caractérisé en ce que
- on réalise l'épaisseur de la couche mince (4) et son matériau en fonction de la pente exigée du flanc oblique (9).
